# EUROPÄISCHE PATENTSCHRIFT

(11) **EP 0 847 608 B1**
(45) Veröffentlichungstag und Bekanntmachung des Hinweises auf die Patenterteilung: **30.06.1999**
(21) Anmeldenummer: 96934376.3
(22) Anmeldetag: 23.08.1996
(51) Int. Cl.: H01S 3/25

(54) **LASERVORRICHTUNG**
LASER DEVICE
DISPOSITIF LASER

(30) Priorität: 29.08.1995 DE 19531755
(43) Veröffentlichungstag der Anmeldung: 17.06.1998
(73) Patentinhaber: SIEMENS AKTIENGESELLSCHAFT, 80333 München (DE)
(72) Erfinder: LUFT, Johann, D-93195 Wolfsegg (DE)
(86) Internationale Anmeldenummer: DE9601576
(87) Internationale Veröffentlichungsnummer: WO9708793

(56) Entgegenhaltungen:
- EP-A- 0 156 014
- EP-A- 0 221 258

## Beschreibung

Die Erfindung bezieht sich auf eine Halbleiter-Laservorrichtung mit einer Vielzahl von in einem laseraktiven Bereich angeordneten Einzellasern nach dem Oberbegriff des Anspruchs 1.

Bei Laserdioden und insbesondere bei Hochleistungslaserdioden führt das Auftreten von verlustarmen internen Ringmoden, oder sonstigen, den gewünschten Laserbetrieb zum Teil erheblich störenden Konkurrenzmoden, die in der Regel von spontan emittierten Photonen, Superlumineszenz oder gestreuter Laserstrahlung angeregt werden, zu einer Beeinträchtigung der Gesamteffizienz der Laserdioden. Der Einfluß solcher Störungen tritt insbesondere bei kurzen Resonatorlängen (beispielsweise von weniger als etwa 300 µm und/oder bei einer vorgesehenen vorderseitigen Entspiegelungsschicht (insbesondere bei Produkten der Spiegelreflexionen Pᵥₒᵣₙₑ • Rₕᵢₙₜₑₙ von weniger als etwa 0,30) auf. Dieses Problem wurde mit zunehmender Verbesserung der bei Halbleiterlaservorrichtungen verwendeten Epitaxieschichten zur Ausbildung der laseraktiven Bereiche wegen der geringeren internen Absorptions- und Streuverluste der Grenzschichten noch vergrößert. Aus der Literatur ist es hierzu bekannt, vgl. Appl. Phys. Lett. 52(16), S. 1320 ff., 1988, daß ein nicht unerheblicher Anteil der Degradationsmechanismen photoneninduziert ist, insbesondere bei GaAs/AlGaAs-Halbleiterlaserdioden. Aus diesem Grunde sind die erwähnten störenden Photonen auch maßgeblich an der Alterung der Laserdiode beteiligt.

Bei Laserdioden mit breiten aktiven Bereichen und daher großer Neigung zur oben geschilderten Störanfälligkeit wird der aktive Bereich mittels Trenngräben in viele schmälere aktive Bereiche geteilt. Bei Laserdioden mit breiten Einzelbereichen (beispielsweise 40 Laserstreifen mit insgesamt 400 µm Breite) oder kurzen Resonatorlängen und/oder Spiegelreflexionen mit Rᵥₒᵣₙₑ • Rₕᵢₙₜₑₙ ≤ 0,30 reicht im allgemeinen diese Maßnahme nicht mehr aus. Bei Vielfachlaseranordnungen wurde bisher dem Problem dadurch begegnet, daß die als V-förmige Gräben ausgebildeten seitlichen Begrenzungen des laseraktiven Bereicns mit einem Material versehen wurden, das die unerwünschten Quer- oder Ringmoden der Laserstrahlung absorbiert oder auskoppelt (vgl. EP-A-221 258-B1). Wurde die Laserspiegelbeschichtung so gewählt, daß Rᵥₒᵣₙₑ • Rₕᵢₙₜₑₙ ≥ 0,3 betrug, reichte die absorptive Eigenschaft von beispielsweise einer Ti- oder auch Cr-Beschichtung in den geätzten lateralen Trenngräben zur Unterdrückung der Konkurrenzmoden aus.

Weitere Vielfachlaseranordnungen sind beispielsweise aus der US 4,792,200 oder der US 5,063,570 bekanntgeworden.

Mit der Erfindung sollen alle den gewünschten Laserbetrieb irgendwie störenden Photonen ganz oder zumindest teilweise beseitigt werden mit dem Ziel, alle wesentlichen charakteristischen Lasereigenschaften wie Schwellstrom, differentielle Steilheit, Spiegelzerstörungsgrenze, spektrales Modenverhalten sowie das Alterungsverhalten zu verbessern.

Der Erfindung liegt daher die Aufgabe zugrunde, eine Halbleiter-Laservorrichtung mit einer Vielzahl von in einem laseraktiven Bereich angeordneten Einzellasern zur Verfügung zu stellen, bei der alle wesentlichen charakteristischen Lasereigenschaften verbessert sind.

Diese Aufgabe wird durch eine Halbleiter-Laservorrichtung nach dem Anspruch 1 gelöst.

Erfindungsgemäß ist vorgesehen, daß sämtliche der äußeren Begrenzungsflächen der Laservorrichtung mit Ausnahme des laseraktiven Bereiches bei den quer zur Austrittsrichtung des Laserlichts verlaufenden vorderen und/oder hinteren Begrenzungsflächen und mit Ausnahme von einigen wenigen freibleibenden Stellen für die Anschlußelektroden oder für die Einbringung von Pumplicht mit einer ganzflächig aufgetragenen Absorptionsschicht zur Auskopplung der für den gewünschten Laserbetrieb störenden Photonen versehen sind.

Geeignete Materialien für die Absorptionsschicht sind beispielsweise Halbleitermaterialien, dielektrische Materialien, Metalloxyde, Metalle und Kunststoffe mit Eigenschaften, die auf die störenden Photonen die beschriebenen Wirkungen zeigen, und welche Materialien auf den äußeren Begrenzungsflächen der Laservorrichtung aufgedampft, aufgesputtert epitaktisch aufgebracht, galvanisiert, aufgeschleudert oder durch sonstige Techniken aufgebracht werden können.

Die erfindungsgemäße Laservorrichtung findet bevorzugtermaßen Anwendung bei einer Vielfachlaseranordnung (Laser-Array) mit phasengekoppelten Laserdioden, namentlich Halbleiterlaserdioden, innerhalb eines laseraktiven Bereichs.

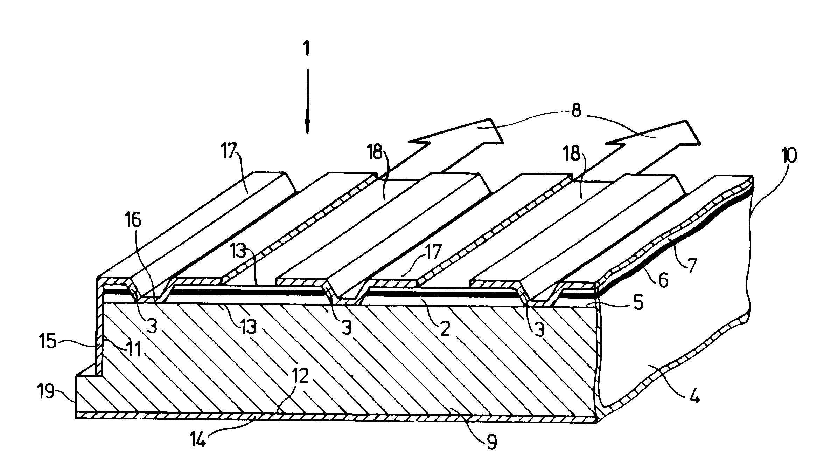

Weitere Vorteile und Ausgestaltungen der Erfindung ergeben sich aus der nachfolgenden Beschreibung eines Ausführungsbeispiels anhand der Figur.

Das Laserarray 1 gemäß Figur besitzt eine Anzahl von in einem laseraktiven Bereich 2 angeordneten phasengekoppelten Einzellaserdioden, die durch grabenförmige Vertiefungen 3, welche durch Ätzen, bzw. durch Sägen erzeugt sind, voneinander unterteilt sind. Das Laserarray 1 umfaßt ein Halbleitersubstrat 4 aus GaAs und hierauf aufgebrachte Epitaxieschichten 5, 6, 7. Aus dem laseraktiven Bereich 2 des Laserarrays 1 wird die Laserstrahlung 8 emittiert.

Das Laserarray 1 gemäß Figur besitzt des weiteren äußere Begrenzungsflächen mit quer zur Austrittsrichtung des Laserlichtes 8 verlaufenden vorderen und hinteren Begrenzungsflächen 9 und 10, und parallel zur Austrittsrichtung des Laserlichts 8 verlaufende seitliche Begrenzungsflächen, von denen in der Figur nur die linke seitliche Begrenzungsfläche 11 dargestellt ist, sowie untere und obere Begrenzungsflächen 12 und 13. Erfindungsgemäß ist vorgesehen, daß wenigstens eine äußere Begrenzungsfläche der Laservorrichtung 1 mit einer wenigstens annähernd ganzflächig aufgetragenen Absorptionsschicht 14 bis 17 versehen ist. Die Absorptionsschicht 14 bis 17 weist ein für das Laserlicht reflexionsverminderndes und/oder absorptives und/oder gegenüber dem Material des laseraktiven Bereiches 2 brechungsindexangepaßtes Material auf. Ein geeignetes Material hierfür ist ein Halbleitermaterial, ein dielektrisches Material, ein Metalloxyd, ein Metall oder ein Kunststoffmaterial mit den auf die störenden Photonen beschriebenen Wirkungen. Diese Materialien können aufgedampft, aufgesputtert, epitaxiert, galvanisiert, aufgeschleudert oder auf sonstige geeignete Weise äußerlich aufgebracht werden. Für den Einsatz als Hochleistungslaserdiode weist das Material der Absorptionsschicht 14 bis 17 insbesondere Germanium oder Silizium auf.

Bei dem in der Figur dargestellten Ausführungsbeispiel sind sämtliche äußere Begrenzungsflächen 9 bis 13 mit der Absorptionsschicht 14 bis 17 versehen, welche mit Ausnahme des laseraktiven Bereiches 2 und den mit den Bezugsziffern 18 und 19 angedeuteten Stellen, auf denen Anschlußelektroden oder sonstige Kontakte vorzusehen sind, oder Pumplicht für die Laservorrichtung eingebracht wird ganzflächig auf den äußeren Begrenzungsflächen und der Oberflächenkontour der äußeren Begrenzungsflächen folgend aufgetragen ist.

## Patentansprüche

1. Halbleiter-Laservorrichtung mit einer Vielzahl von in einem laseraktiven Bereich (2) angeordneten Einzellasern innerhalb von äußeren Begrenzungsflächen (9 bis 13) mit quer zur Austrittsrichtung des Laserlichtes (8) verlaufenden vorderen und hinteren Begrenzungsflächen (9, 10) und parallel zur Austrittsrichtung des Laserlichts verlaufenden seitlichen, sowie unteren und oberen Begrenzungsflächen (11, 12, 13),
dadurch gekennzeichnet, daß
sämtliche der äußeren Begrenzungsflächen (9 bis 13) der Laservorrichtung (1) mit Ausnahme des laseraktiven Bereiches (2) bei den quer zur Austrittsrichtung des Laserlichts (8) verlaufenden vorderen und/oder hinteren Begrenzungsflächen (9, 10) und mit Ausnahme von einigen wenigen freibleibenden Stellen für die Anschlußelektroden oder für die Einbringung von Pumplicht mit einer ganzflächig aufgetragenen Absorptionsschicht (14 bis 17) zur Auskopplung der für den gewünschten Laserbetrieb störenden Photonen versehen sind.

2. Laservorrichtung nach Anspruch 1, dadurch gekennzeichnet, daß die seitlichen Begrenzungen des laseraktiven Bereiches (2) durch grabenförmige Vertiefungen (3) ausgebildet sind, in denen die Absorptionsschicht aufgebracht ist.

3. Laservorrichtung nach Anspruch 1 oder 2, dadurch gekennzeichnet, daß die in dem laseraktiven Bereich (2) innerhalb der äußeren Begrenzungsflächen (9 bis 13) angeordneten Einzellaser streifenförmig nebeneinander auf einem Halbleitersubstrat (4) angeordnete Halbleiterlaser darstellen.

4. Laservorrichtung nach Anspruch 3, dadurch gekennzeichnet, daß die Einzellaser phasengekoppelte Laserdioden darstellen.

## Claims

1. Semiconductor laser device with a plurality of individual lasers, arranged in an active laser region (2), within outer boundary faces (9 to 13) comprising front and back boundary faces (9, 10) extending transversely to the output direction of the laser light (8) and lateral boundary faces (11), extending parallel to the output direction of the laser light, as well as bottom and top boundary faces (12, 13), characterized in that all the outer boundary faces (9 to 13) of the laser device (1), with the exception of the active laser region (2) in the case of the front and/or back boundary faces (9, 10) which extend transversely with respect to the output direction of the laser light (8), and with the exception of a few free locations for the connection electrodes or for injecting pump light, are provided with an absorption layer (14 to 17) which is applied surface-wide and is intended to extract the photons which interfere with the desired laser operation.

2. Laser device according to Claim 1, characterized in that the lateral boundaries of the active laser region (2) are formed by trench-like indentations (3), in which the absorption layer is applied.

3. Laser device according to Claim 1 or 2, characterized in that the individual lasers, which are arranged in the active laser region (2) within the outer boundary faces (9 to 13), constitute strip-like semiconductor lasers arranged next to one another on a semiconductor substrate (4).

4. Laser device according to Claim 3, characterized in that the individual lasers constitute phase-coupled laser diodes.

## Revendications

1. Dispositif laser à semi-conducteur possédant un grand nombre de lasers élémentaires disposés dans une région laser-active (2), à l'intérieur de surfaces de limitation extérieures (9 à 13) munies de surfaces de limitation avant et arrière (9, 10) s'étendant transversalement à la direction de sortie de la lumière laser (8) et de surfaces de limitation (11, 12, 13) latérales, de même qu'inférieures et supérieures s'étendant parallèlement à la direction de sortie de la lumière laser,
caractérisé en ce que
toutes les surfaces de limitation extérieures (9 à 13) du dispositif laser (1), à l'exception de la région laser-active (2) dans les surfaces de limitation (9, 10) avant et/ou arrière s'étendant transversalement à la direction de sortie de la lumière laser (8), et à l'exception d'un petit nombre de zones laissées libres pour les électrodes de connexion ou pour l'introduction de la lumière de pompage, sont munies d'une couche absorbante (14 à 17) déposée sur toute la surface pour le découplage des photons perturbateurs du fonctionnement laser souhaité.

2. Dispositif laser selon la revendication 1, caractérisé en ce que les limitations latérales de la région laser active (2) sont formées par des creux (3) en forme de tranchée, dans lesquelles la couche d'absorption est déposée.

3. Dispositif laser selon la revendication 1 ou 2, caractérisé en ce que les lasers élémentaires disposés dans la région laser active (2) à l'intérieur des surfaces de limitation extérieures (9 à 13) représentent des lasers à semi-conducteur disposés les uns à côté des autres en bandes sur un substrat semi-conducteur (4).

4. Dispositif laser selon la revendication 3, caractérisé en ce que les lasers élémentaires représentent des diodes lasers couplées en phase.
